Europäisches Patentamt

European Patent Office

Office européen des brevets

(19)

(11) **EP 0 954 097 A1**

(12) **DEMANDE DE BREVET EUROPEEN**

(43) Date de publication:
03.11.1999 Bulletin 1999/44

(51) Int Cl.$^6$: **H03H 7/12**

(21) Numéro de dépôt: 99401047.8

(22) Date de dépôt: 29.04.1999

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: 29.04.1998 FR 9805391

(71) Demandeur: **Matra Nortel Communications**
**29562 Quimper Cedex 09 (FR)**

(72) Inventeur: **Schieblich, Christian**
**89075 Ulm (DE)**

(74) Mandataire: **Loisel, Bertrand**
**Cabinet Plasseraud,**
**84, rue d'Amsterdam**
**75440 Paris Cédex 09 (FR)**

(54) **Filtre passe-bande accordable**

(57) Le filtre passe-bande accordable est situé à l'entrée d'un récepteur de radiocommunication. Il comporte deux résonateurs (10). Chacun de ces résonateurs a un noeud d'entrée (11) et comporte, entre son noeud d'entrée et la masse, un montage parallèle d'un élément résonant à ligne de transmission (12) et d'au moins une capacité variable (13) commandée par une tension d'accord (Vacc). Un couplage capacitif (23,24) est prévu d'une part entre une entrée (21) du filtre et le noeud d'entrée (11) de l'un des résonateurs, et d'autre part entre le noeud d'entrée (11) de l'autre résonateur et une sortie (22) du filtre. Le couplage entre les résonateurs (10) est assuré par une inductance (20) connectée entre leurs noeuds d'entrée.

FIG.2.

## Description

La présente invention concerne un filtre radiofréquence utilisé à l'étage d'entrée d'un récepteur de radiocommunication. Elle concerne plus particulièrement un filtre passe-bande accordable en fréquence.

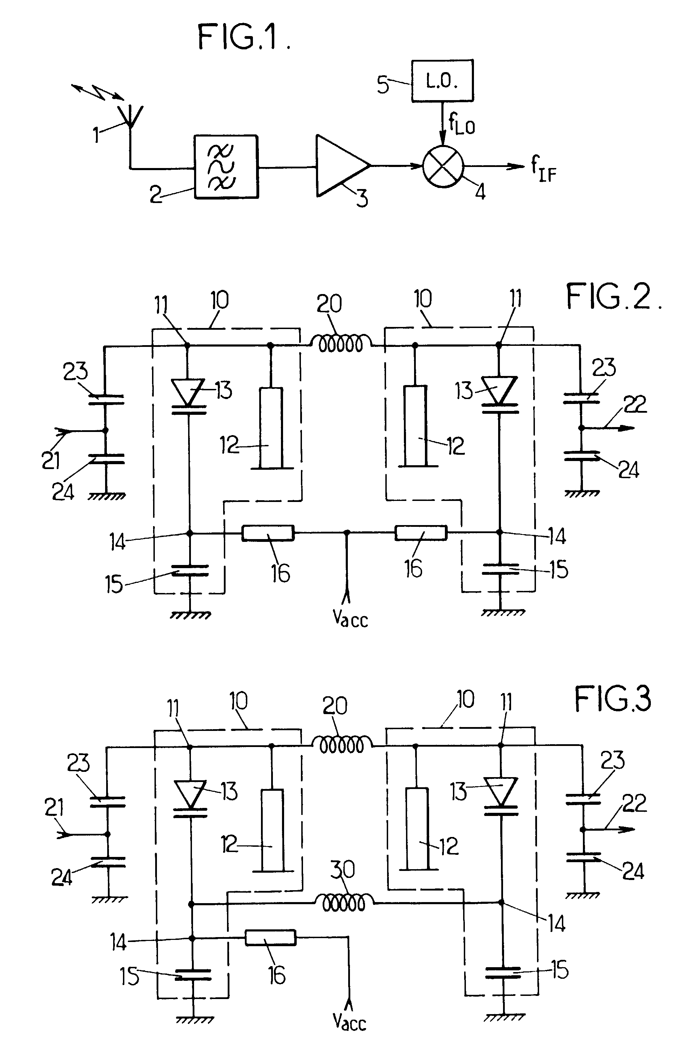

La figure 1 illustre schématiquement l'étage d'entrée d'un récepteur de radiocommunication. Le signal radio capté par l'antenne 1 est soumis au filtre passe-bande 2, avant d'être amplifié par un amplificateur 3. Le mélangeur 4 du premier étage reçoit le signal radio filtré et amplifié et le mélange avec une onde de fréquence $f_{LO}$ délivré par un oscillateur local 5, pour produire un signal modulé autour d'une fréquence intermédiaire $f_{IF}$.

Dans certaines applications, il est requis que le filtre passe-bande 2 présente une coupure relativement abrupte au-dessus de sa bande passante, le but étant de réduire fortement les composantes spectrales de fréquences voisines de $f_{LO}+f_{IF}$ à l'entrée du mélangeur 4, la fréquence centrale du filtre étant $f_{LO}-f_{IF}$. A titre d'exemple, pour une fréquence intermédiaire $f_{IF}$ de 90 MHz, il peut être requis une atténuation de 15 dB à 45 MHz au-dessus de la fréquence centrale du filtre.

Lorsque le récepteur est accordable en fréquence, en réglant la fréquence $f_{LO}$ de l'oscillateur local 5, il faut que ce gabarit du filtre passe-bande 2 puisse être translaté suivant la fréquence d'accord. Cette translation est fréquemment assurée en utilisant non pas un seul filtre 2, mais un banc de filtres passe-bande sélectionnés selon la fréquence d'accord. Cette solution requérant l'emploi de plusieurs filtres n'est pas économique.

Une autre solution est d'utiliser un filtre passe-bande accordable par réglage de sa fréquence de résonance. Théoriquement, il serait souhaitable de réaliser l'accord en changeant à la fois les inductances et les capacités du filtre de façon à maintenir constante l'impédance caractéristique $\sqrt{L/C}$ pour avoir la même réponse du filtre sur toute la gamme d'accord. Mais en pratique, le réglage d'accord est réalisé à l'aide de diodes à capacité variable (varicap), les inductances étant indépendantes de la fréquence. Il en résulte une modification de la forme et de la largeur de bande dans la réponse du filtre lorsque la fréquence d'accord change.

Le plus souvent, les filtres passe-bande d'entrée des récepteurs de radiocommunication comprennent des résonateurs associés avec un couplage capacitif. Or un filtre à couplage capacitif présente un pôle de transmission au-dessous de la bande passante, alors qu'au-dessus de la bande passante, l'atténuation tend vers une valeur constante en raison du diviseur capacitif formé entre la capacité de couplage et les capacités des résonateurs. En conséquence, il est relativement délicat de réaliser une coupure abrupte au-dessus de la bande passante, et il est extrêmement difficile de réaliser cette coupure abrupte sur toute la gamme de fréquence d'accord lorsque la largeur de cette gamme est relativement importante (par exemple 50 MHz).

Le brevet américain 5715531 décrit un filtre radiofréquence composé de deux résonateurs formés chacun par une inductance en parallèle avec une capacité variable. Le couplage entre les deux résonateurs résulte de l'inductance mutuelle entre les deux inductances.

Le brevet américain 5 392 011 décrit un filtre accordable comportant deux résonateurs formés de circuits série et couplés au moyen d'une inductance de couplage.

Un but de la présente invention est de proposer un filtre passe-bande présentant une coupure relativement abrupte au-dessus de la bande passante et pouvant être accordé sur une assez large gamme de fréquences.

L'invention propose ainsi un filtre passe-bande accordable pour l'entrée d'un récepteur de radiocommunication, comprenant:

- deux résonateurs, chaque résonateur ayant un noeud d'entrée et comportant, entre son noeud d'entrée et la masse, un montage parallèle d'un élément résonant à ligne de transmission et d'au moins une capacité variable commandée par une tension d'accord;
- des moyens de couplage capacitif d'une part entre une entrée du filtre et le noeud d'entrée de l'un des résonateurs, et d'autre part entre le noeud d'entrée de l'autre résonateur et une sortie du filtre; et
- une inductance de couplage connectée entre les noeuds d'entrée des résonateurs.

On a constaté qu'une telle structure de filtre pouvait respecter le gabarit de fréquence sur une assez large gamme de fréquences d'accord. Le couplage inductif entre les résonateurs fait que le filtre présente un pôle au-dessus de la bande passante et que la transmission tend vers zéro pour les hautes fréquences du fait que l'inductance de couplage associée aux capacités du résonateur présente un comportement passe-bas.

Dans un mode de réalisation préféré du filtre selon l'invention, chaque résonateur comporte au moins une diode à capacité variable connectée entre son noeud d'entrée et un second noeud, et une autre capacité connectée entre le second noeud et la masse, le filtre comprenant une inductance de couplage supplémentaire connectée entre les seconds noeuds des deux résonateurs.

Le couplage supplémentaire dépend alors de la fréquence d'accord. Par cette dépendance, on peut améliorer le comportement à large bande du filtre en rendant sa fonction de transfert moins sensible à la fréquence d'accord.

D'autres particularités et avantages de la présente invention apparaîtront dans la description ci-après d'exemples de réalisation non limitatifs, en référence aux dessins annexés, dans lesquels :

- la figure 1, précédemment commentée, est un schéma de principe du premier étage d'un récepteur de radiocommunication ; et
- les figures 2 et 3 sont les schémas de deux filtres passe-bande accordables selon l'invention.

Le filtre passe-bande représenté sur la figure 2 comprend deux résonateurs 10 composés de deux branches montées en parallèle entre un noeud d'entrée 11 et la masse, à savoir :

- une branche formée par un élément résonant à ligne de transmission 12, et
- une branche capacitive formée par une diode à capacité variable (varicap) 13 connectée entre le noeud d'entrée 11 et un autre noeud 14, et par un condensateur 15 connecté entre le noeud 14 et la masse.

Une tension continue $V_{acc}$ règle la capacité de chaque diode varicap 13 en la polarisant en inverse par l'intermédiaire d'une résistance 16 reliée au noeud 14 de chaque résonateur 10.

Chacun des éléments 12 est un morceau de ligne de transmission court-circuité, plus court qu'un quart de la longueur d'onde correspondant à sa fréquence de résonance, dont un conducteur est relié au noeud 11 et l'autre conducteur à la masse. Un tel élément 12 procure un facteur de qualité moins bas qu'une inductance ordinaire aux hautes fréquences. Il constitue en lui-même un résonateur dont la fréquence de résonance $f_0$ se trouve au-dessus de la bande de fonctionnement du filtre, et qui peut être modélisé par le montage parallèle d'une résistance, d'une capacité et d'une inductance.

L'association en parallèle de cet élément à ligne de transmission 12 avec la capacité réglable de la branche 13,15 permet de faire varier la fréquence de résonance de l'ensemble du résonateur 10 qui détermine la fréquence d'accord du filtre. La valeur de la tension $V_{acc}$ règle ainsi la fréquence de résonance de chaque résonateur 10, et donc la fréquence centrale du filtre.

Le couplage entre les deux résonateurs 10 est assuré par une inductance 20 connectée entre leurs noeuds d'entrée 11. Ce type de couplage provoque un pôle de transmission au-dessus de la bande passante du filtre, et un comportement passe-bas aux hautes fréquences.

Un couplage capacitif est prévu d'une part entre l'entrée 21 du filtre et l'un des résonateurs 10, et d'autre part entre la sortie 22 du filtre et l'autre résonateur 10. Chaque noeud d'entrée 11 d'un résonateur 10 est ainsi relié à la masse par l'intermédiaire de deux condensateurs en série 23,24, l'entrée 21 ou la sortie 22 du filtre se trouvant entre ces deux condensateurs 23,24.

Un filtre du type représenté sur la figure 2 a permis de réaliser le gabarit de fréquence souhaité (moins 15 dB à 45 MHz au-dessus de la bande passante) sur une large gamme d'accord (de 380 à 430 MHz), avec des éléments 12 de fréquence de résonance $f_0$ =620 MHz et une inductance de couplage 20 de 150 nH.

Une légère variation du couplage, de sur-critique à sous-critique lorsque la fréquence d'accord augmente, peut être observée. Cette variation du couplage peut être réduite en utilisant un élément de couplage inductif supplémentaire entre les noeuds 14 des résonateurs 10, comme illustré par l'inductance 30 sur la figure 3. Cette inductance 30 produit une composante de couplage dépendant de l'accord qui améliore la constance du couplage sur la gamme d'accord.

## Revendications

1.    Filtre passe-bande accordable pour l'entrée d'un récepteur de radiocommunication, comprenant:

- deux résonateurs, chaque résonateur (10) ayant un noeud d'entrée (11) et comportant, entre son noeud d'entrée et la masse, un montage parallèle d'un élément résonant à ligne de transmission (12) et d'au moins une capacité variable (13) commandée par une tension d'accord ($V_{acc}$);
- des moyens de couplage capacitif (23,24) d'une part entre une entrée (21) du filtre et le noeud d'entrée (11) de l'un des résonateurs, et d'autre part entre le noeud d'entrée (11) de l'autre résonateur et une sortie (22) du filtre; et
- une inductance de couplage (20) connectée entre les noeuds d'entrée des résonateurs (10).

2.    Filtre selon la revendication 1, dans lequel chaque résonateur (10) comporte au moins une diode à capacité variable (13) connectée entre son noeud d'entrée (11) et un second noeud (14), et une autre capacité (15) connectée entre le second noeud et la masse, le filtre comprenant une inductance de couplage supplémentaire (30) connectée entre lesdits seconds noeuds (14) des deux résonateurs.

## FIG.1.

## FIG.2.

## FIG.3

**Office européen des brevets**

## RAPPORT DE RECHERCHE EUROPEENNE

Numéro de la demande

EP 99 40 1047

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | US 5 715 531 A (LIANG REN-YUH ET AL) 3 février 1998 (1998-02-03) * le document en entier * --- | 1,2 | H03H7/12 |
| Y | US 5 392 011 A (LI RICHARD C) 21 février 1995 (1995-02-21) * colonne 2, ligne 45 - colonne 3, ligne 58; figure 1 * ----- | 1,2 | |

**DOMAINES TECHNIQUES RECHERCHES (Int.Cl.6)**

H03H
H03J

Le présent rapport a été établi pour toutes les revendications

| Lieu de la recherche | Date d'achèvement de la recherche | Examinateur |
|---|---|---|
| LA HAYE | 27 juillet 1999 | Coppieters, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**                EP 99 40 1047

La présente annexe indique les membres de la famille de brevets relatifs aux documents brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

27-07-1999

| Document brevet cité au rapport de recherche | Date de publication | Membre(s) de la famille de brevet(s) | Date de publication |
|---|---|---|---|
| US 5715531 A | 03-02-1998 | AUCUN | |
| US 5392011 A | 21-02-1995 | AUCUN | |

EPO FORM P0460

Pour tout renseignement concernant cette annexe : voir Journal Officiel de l'Office européen des brevets, No.12/82